# EUROPEAN PATENT APPLICATION

(11) **EP 0 692 875 A1**
(43) Date of publication of application: **17.01.1996**
(21) Application number: 95109587.6
(22) Date of filing: 19.06.1995
(51) Int. Cl.: H03K 17/16, H01L 29/78

(54) **MOS N-channel transistor protection**

(30) Priority: 14.07.1994 GB 9414261
(71) Applicant: MOTOROLA GmbH, D-65232 Taunusstein (DE)
(72) Inventor: Meyer, Robert Anton, D-81245 Munich (DE)
(74) Representative: Hudson, Peter David

(57) **Abstract**

In a CMOS output circuit having a P-channel transistor (3) and an N-channel transistor (5), whose drains are coupled via node (4) to an output (2), a diffused resistor/diode structure (6) is provided between the node (4) and the N-channel transistor (5) to prevent ESD pulses across the output from passing through the N-channel transistor (5) and destroying it. Instead the pulse energy takes the low impedance path through the diode (8) to ground. The resistor (7) in series with transistor (5) means that the impedance of the path through the transistor (5) is always higher than that through the diode (8).

## Description

### FIELD OF THE INVENTION

This invention relates to protection of N-channel MOS transistors, and more particularly to protection of such transistors from electrostatic discharge (ESD), which can destroy the transistors.

### BACKGROUND OF THE INVENTION

As is well known, N-channel transistors, in both MOS and CMOS technology are highly susceptible to damage from ESD. The N-channel transistor failure is caused by current overstress due to secondary breakdown during an ESD pulse ("punch through" effect): the drain-to-source resistivity drops to typically 2-4 Ohms so that the current through the junction increases significantly and causes thermal destruction. N-channel transistors are far more susceptible to such damage because the ESD resistivity of the N-channel transistor is much lower than that of P-channel transistors, which are much larger. Generally, the resistivity of the N-channel transistor is approximately half the value of the P-channel transistor. Therefore, in a CMOS device, the N-channel, rather than the P-channel transistor, will fail first from ESD.

One known method of N-channel transistor protection is to increase the spacing between the drain contact and gate. This limits the current through the junction and therefore improves the performance of the transistor. However, the amount of energy passing through the junction is still the same and therefore the transistor still fails, but at a higher level of the ESD. Furthermore, increasing the spacing beyond a certain limit produces no further increase in ESD protection and so the improvement in ESD protection achieved by this method is limited.

### BRIEF SUMMARY OF THE INVENTION

It is therefore an object of the present invention to provide ESD protection which does not suffer from the disadvantages of the known method.

Accordingly, the invention provides a MOS circuit comprising an N-channel transistor having its drain coupled to an output and its gate coupled to an input, a diffused N-type resistor coupled between the output and the drain of the N-channel transistor, where the N-type resistor is diffused into a P-type material thereby providing a diode junction coupled to a ground reference potential.

In a preferred integrated circuit structure the N-channel transistor and the diffused N-type resistor are formed in respective P-wells in an N-substrate.

In a preferred embodiment the circuit is produced in CMOS technology and further comprises a P-channel transistor having its gate coupled to the input and its drain coupled to the output via a node coupled to the drain of the N-channel transistor, wherein the diffused resistor is coupled between the node and the drain of the N-channel transistor.

### BRIEF DESCRIPTION OF THE DRAWINGS

One embodiment of the invention will now be more fully described, by way of example, with reference to the drawings, of which:
FIG. 1 shows a schematic diagram of a known CMOS output circuit;
FIG. 2 shows a schematic diagram of a CMOS output circuit, similar to that of FIG. 1, including one embodiment of the invention; and
FIG. 3 shows a schematic cross-sectional view through an integrated structure of the circuit of FIG. 2.

### DETAILED DESCRIPTION

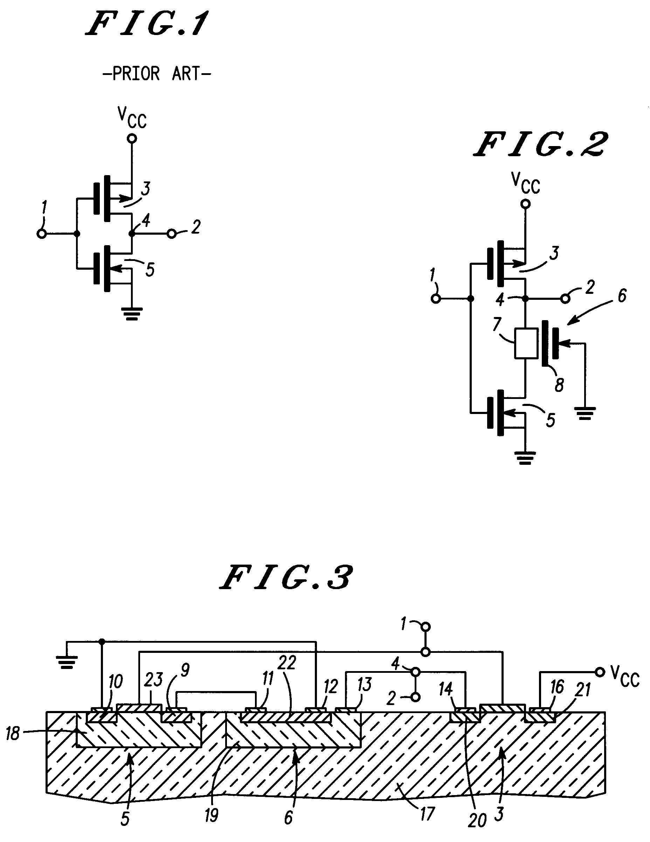

Thus, as shown in FIG. 1, a known CMOS output circuit includes an input 1, an output 2, a P-channel transistor 3 having its drain coupled to the output 2 via a node 4 and its source coupled to V_{cc}, and an N-channel transistor 5 having its drain coupled to the output 2 via the node 4 and its source coupled to ground reference potential. The gates of the P-channel and N-channel transistors 3 and 5 are coupled together and to the input 1.

If an ESD pulse is applied between the output 2 and the ground reference potential, the N-channel transistor 5 is destroyed by the amount of electrical current flowing through its drain and source electrodes from the node 4 to the ground reference potential.

As shown in FIG. 2, where the same components have the same reference numerals as in FIG. 1, according to one embodiment of the present invention, a diffused resistor/diode structure 6 is provided between the node 4 and the N-channel transistor 5. The resistor/diode structure 6 provides an ohmic resistor 7 between the node 4 and the N-channel transistor 5 and a diode 8 between the resistor 7 and ground reference potential. In this case, the ESD pulse applied between the output 2 and ground reference potential does not pass through the sensitive N-channel transistor 5, but, instead, passes through the resistor/diode structure 6, since it provides a lower impedance path than the impedance of the path through the N-channel transistor 5, which has been increased by the value of the ohmic resistor 7.

As best shown in FIG. 3, the circuit, when manufactured in P-well, N-substrate technology, includes an N-type substrate 17 into which are diffused P-well 18 forming part of the N-channel transistor 5, P-well 19 forming part of the resistor/diode structure 6, and P-type regions 20 and 21 forming the drain 14 and source 16 of the P-channel transistor 3.

The P-well 19 is coupled to ground reference potential via contact 13, as shown. Within the P-well 19 there is provided an N+ region 22 forming resistor 7, with contacts 11 and 12 at the ends thereof. Contact 12 is coupled to the output 2, via node 4.

The N-channel transistor 5 further consists of two N+ diffusion regions forming, respectively, the source 10 coupled to ground reference potential, and the drain 9 coupled to contact 11 at one end of resistor 7. The N-channel between the source 10 and drain 9 is covered by N-channel gate 23, which is coupled to the input 1.

The drain 14 of transistor 3 is coupled to the output 2 via node 4 and the source 16 is coupled to supply voltage V_{cc}. The P-channel between the source 16 and drain 14 is covered by P-channel gate 15, which is coupled to the input 1.

Due to the parasitic diode function of the resistor/diode structure 6, the contacts 11 and 12 are also coupled to ground reference potential via the N+/P- junction of the N+ diffusion region 22 embedded in the P-well 19 of the resistor/diode structure 6 and the contact 13.

Thus, an ESD pulse applied to the output 2 relative to ground reference potential will pass from the output 2 via node 4 to contact 12, where the ohmic resistance between contacts 11 and 12 will inhibit the energy from proceeding through the sensitive N-channel transistor 5. Instead the pulse voltage will turn on the parasitic N+/P- diode 8 and will follow the low impedance path to ground reference potential via the contact 13.

It will also be understood that the integrated circuit of FIG. 3 offers the following possible advantage: the proximity of the two P-wells 18 and 19 forms a PNP bipolar transistor whose two diode junctions may respectively conduct during ESD, depending on the polarity of the discharge.

It will be appreciated that although only one particular embodiment of the invention has been described in detail, various modifications and improvements can be made by a person skilled in the art without departing from the scope of the present invention.

## Claims

1. A MOS circuit comprising an N-channel transistor having its drain coupled to an output and its gate coupled to an input, a diffused N-type resistor coupled between the output and the drain of the N-channel transistor, where the N-type resistor is diffused into a P-type material thereby providing a diode junction coupled to a ground reference potential.

2. A MOS circuit according to claim 1, which is produced in CMOS technology and further comprises a P-channel transistor having its gate coupled to the input and its drain coupled to the output via a node coupled to the drain of the N-channel transistor, wherein the diffused resistor is coupled between the node and the drain of the N-channel transistor.

3. A MOS integrated circuit comprising:
an N-substrate;
a first P-well formed in the substrate, the first P-well having formed therein an N-channel transistor having its drain coupled to an output and its gate coupled to an input;
a second P-well formed in the substrate, the second P-well having formed therein a diffused N-type resistor coupled between the output and the drain of the N-channel transistor, the N-type resistor providing a diode junction coupled to a ground reference potential.

4. A MOS integrated circuit according to claim 1, which is produced in CMOS technology and further comprises a P-channel transistor formed in the substrate, the P-channel transistor having its gate coupled to the input and its drain coupled to the output via a node coupled to the drain of the N-channel transistor, wherein the diffused resistor is coupled between the node and the drain of the N-channel transistor.
